# EUROPÄISCHE PATENTSCHRIFT

(11) **EP 1 646 101 B1**
(45) Veröffentlichungstag und Bekanntmachung des Hinweises auf die Patenterteilung: **13.08.2008**
(21) Anmeldenummer: 05450124.2
(22) Anmeldetag: 21.07.2005
(51) Int. Cl.: H01M 8/04, H01M 8/24, G01R 31/36

(54) **Verfahren zur Überwachung des Betriebszustandes eines Brennstoffzellenstapels**
Method of monitoring the operational state of a fuel cell stack
Procédé de surveillance de l'état de fonctionnement d'un empilement de pile à combustible

(30) Priorität: 07.10.2004 AT 16782004
(43) Veröffentlichungstag der Anmeldung: 12.04.2006
(73) Patentinhaber: AVL List GmbH, 8020 Graz (AT)
(72) Erfinder: Ramschak, Erich, 8071 Vasoldsberg (AT)
(74) Vertreter: Babeluk, Michael

(56) Entgegenhaltungen:
- DE-A1- 10 036 572
- JP-A- 2004 038 246
- US-A- 6 002 238
- US-A1- 2004 091 759
- US-B1- 6 762 587

## Beschreibung

Die Erfindung betrifft ein Verfahren zur Überwachung des Betriebszustandes eines Brennstoffzellenstapels bestehend aus einer Vielzahl von in Serie geschalteten Einzelzellen.

Eine einzelne Zelle eines Brennstoffzellenstapels kann Ausgangspannungen im Bereich von ca. 0.7 bis ca. 1 Volt liefern. Um die gewünschten Leistungen bei gegebener Zellfläche zu erhalten, werden einzelne Zellen elektrisch in Serie zu einem so genannten Stapel bzw. Stack verschaltet. Das gilt für alle Typen von Brennstoffzellen und elektrischen Speicherelementen wie Batterien.

Naturgemäß ergibt sich aus dieser Serienschaltung das Gefahrenpotential, dass ein Versagen nur einer einzelnen Zelle bereits zum Ausfall und damit zum Abschalten des gesamten Stapels führt. Dieses mögliche Versagen einer Zelle wird zurzeit durch die Messung von allen Einzelzellspannungen überwacht. Große Zellstapel erfordern daher auch einen sehr aufwendigen und massiven messtechnischen Aufwand.

In der Fertigung von Brennstoffzellen erfordert die Qualitätssicherung eine Überprüfung der Funktionalität bzw. der Performance von allen Zellen. Dies geschieht - sofern die Kontaktierungen vorhanden sind - mittels Messung der einzelnen Zellspannungen. Aufgrund des großen Aufwands ist die Messung von einzelnen Zellspannungen jedoch weder bei der Fertigung noch während des Betriebs von Brennstoffzellen erwünscht.

im Labor wird alternativ bisher die so genannte Impedanzspektroskopie zur Detektierung des Betriebszustandes bzw. des "Gesundheitszustandes" des Brennstoffzellenstapels verwendet. Dabei wird die komplexe Impedanz (d.h. Impedanzortskurve) des Brennstoffzellenstapels über einen bestimmten Frequenzbereich gemessen und zumeist mit Referenzkurven verglichen.

Je nachdem bei welcher Frequenz sich typische Veränderungen im Impedanzverlauf einstellen, kann nun unterschieden werden, ob diese Veränderung von der Anode, der Kathode oder der Membran der Einzelzellen ausgehen. Das Verfahren beruht auf der Tatsache, dass das elektrische Ersatzschaltbild für den Brennstoffzellenstapel eine Serien-Parallelschaltung von Tiefpassgliedern 1. Ordnung ist, deren Grenzfrequenzen deutlich weit auseinander liegen und daher die gewünschte Selektivität erreicht werden kann.

Im Wesentlichen sind es folgende Effekte im Brennstoffzellenstapel (beispielsweise bei einer mit Luft und H₂ betriebenen PEM-Brenstoffzelle), die eine Einzelspannungsüberwachung notwendig machen.
■ Luft- oder Wasserstoff-Unterversorgung an Kathode bzw. Anode (Unterstöchiometrie). Effekt: U/I Kennlinie fällt schon bei kleineren Strömen ab.
■ Membran: Bildung von elektrischen Kurzschlüssen bzw. Gaskurzschlüssen Effekt: Uₒ (Spannung bei Strom = 0) verändert sich
■ Elektrodenalterung. Effekt: U/I Kennlinie fällt steiler ab, größerer Ohmscher Widerstand durch Korrosionseffekte

Bei der angewandten Einzelzellspannungsmessung zur Überwachung eines Brennstoffzellestapels ist es üblich, bei einer Stackgröße von z.B. 500 Einzelzellen entweder alle 500 Spannungen oder zumindest jede zweite Zelle, d.h. 250 Spannungen einzeln zu messen und auszuwerten. Die Spannungsmessung für derart viele Kanäle ist extrem aufwendig, kosten-, gewichts- und platzintensiv (z.B. Verdrahtung, Stecker, A/D Wandler, hohe Spannungen auf engem Bauraum, Auswerteelektronik mit hohem Gleichtaktbereich).

Eine Serientauglichkeit kann aus Kostengründen damit nicht erreicht werden, bzw. nur in Fällen von Nischenanwendungen, in denen hohe Kosten akzeptiert werden können.

Ein aktuelles Beispiel für den Aufwand ist das CUTE Projekt (CUTE = Clean Urban Transport for Europe), bei welchem 30 mit Brennstoffzellen ausgerüstete Citaro-Buse in 9 Europäischen Städten betrieben werden. Die Busse sind mit zwei PEM-Brennstoffzellen ausgerüstet. Der Elektromotor hat eine Antriebsleistung von 200kW bei 600V Spannung. Daraus kann man schließen, dass ca. 1000 Einzelzellen zu einem Stack zusammengeschaltet sind. Die einzelnen Zellen, bzw. mindestens jede zweite Zelle, sind mittels Golddraht verdrahtet und werden permanent gemessen sowie täglich ausgewertet (d.h. großer Mess-, Datenspeicher- und Analyseaufwand)

Verfahren die auf der Impedanzspektroskopie beruhen, beziehen sich auf eingespeicherte oder erlernte Referenzkurven bzw. Referenzwerte. Diese Referenzen repräsentieren Sollwerte für einen "gesunden", d.h. unkritischen, Betriebszustand. Das bedeutet auch, dass sämtliche Betriebszustände unter den verschiedenen Konditionen (Druck, Temperatur, Feuchte, usw.) für jede einzelne gefertigte Brennstoffzelle im Vorhinein bekannt und abgespeichert sein müssen. Bei der Kalibrierung von großen Stückzahlen wird der Zeit- und Kostenaufwand daher schnell relevant.

Für Stacks mit großer Zellenanzahl wird auf statistischem Wege die Normalverteilung der einzelnen Zellenimpedanzen angenommen. Einzelne "Ausreißer" sind praktisch nicht detektierbar oder können nur wiederum mittels Einzelzellspannungsmessung erkannt werden. Dieses Verfahren ist außerdem nur für stationäre Lastzustände optimal anwendbar.

Die Impedanzspektroskopie ist zudem zeitintensiv, da bei jeder der schrittweise ansteigenden Frequenz die Impedanz im eingeschwungenen Zustand gemessen werden muss.

Für den praktischen Einsatz eines Brennstoffzellenstapels mit einer Vielzahl von Einzelzellen ist es zielführend, außer dem Defekt einer einzelnen Zelle auch die Schwelle dazu eindeutig zu erkennen um mit sicheren Gegenmaßnahmen eingreifen zu können. Das kann im Extremfall zum Abschalten des gesamten Stacks führen. Dieses sichere Erkennen ist bei Verfahren, die sich auf Vergleichskurven bzw. Annahmen von statistischen Verteilungen beziehen, nicht gewährleistbar.

Aufgabe der Erfindung ist es, ein Verfahren zur Überwachung des Betriebszustandes eines Brennstoffzellenstapels bestehend aus einer Vielzahl von in Serie geschalteten Einzelzellen mit wesentlich geringerem Messaufwand vorzuschlagen, wobei sowohl Defekte als auch kritische Betriebszustände von einzelnen oder mehreren Zellen detektiert werden sollen, um rechtzeitig erforderliche Gegenmaßnahmen zum Schutz der Brennstoffzelle einleiten zu können.

Zudem soll es möglich sein, mit kleinst möglichen Kontaktierungsaufwand (d.h. im Idealfall nur eine Strom- und Spannungsmessung) bei der Fertigung von Brennstoffzellen zur Qualitätssicherung auf die Funktionalität und Performance von allen einzelnen Zellen schließen zu können.

Diese Aufgabe wird erfindungsgemäß dadurch gelöst, dass dem Brennstoffzellenstape! ein niederfrequentes Strom- oder Spannungssignal eingeprägt wird, dass das sich ergebende Spannungs- oder Stromsignal gemessen wird und dass aus zumindest einer Änderung des Oberwellenanteils des Signals auf den Betriebszustand von Einzelzellen des Brennstoffzellenstapels geschlossen wird. Beispielsweise kann von einer Änderung des Klirrfaktors (definiert als das Verhältnis der Grundschwingung zu deren Oberwellenanteile), auf den Betriebszustand der Einzelzellen des Brennstoffzellenstapels geschlossen werden.

Treten Defekte oder kritische Zustände in der Brennstoffzelle auf, dann resultieren daraus Nichtlinearitäten in der Systemantwort. Diese Nichtlinearitäten verzerren das ursprünglich eingeprägte lineare Signal und erzeugen Oberwellen d.h. der Klirrfaktor wird signifikant vergrößert. Das Maß des Klirrfaktors bzw. das Vorhandensein von Oberwellen stellt die Korrelation zu den zu überwachenden Größen im Stack her.

Beispielsweise kann nun mittels einer einzelnen bzw. mit sehr wenigen Spannungsmessungen - z.B. acht Messkanäle pro 1000 Zellen - sowie durch die Messung des eingeprägten Laststroms die sehr aufwändige Einzelzellspannungs-überwachung ersetzt werden. Bei einer signifikanten Änderung des Klirrfaktors kann entschieden werden, ob und welche Maßnahmen zum Schutz bzw. Regenerieren der Brennstoffzelle notwendig sind. Keine der bekannten Methoden kann im laufenden Betrieb mittels Messung von nur einer Spannung bzw. sehr wenigen Spannungen auf den Zustand der Strom-/Spannungskennlinie von Einzelzellen Rückschlüsse ziehen.

Erfindungsgemäß wird von einem sich vergrößernden Oberwellenanteil des Signals auf einen nichtlinearen Betriebszustand zumindest einer der Einzelzellen des Brennstoffzellenstapels geschlossen.

Das erfindungsgemäße Messverfahren geht von folgendem methodischen Ansatz aus:

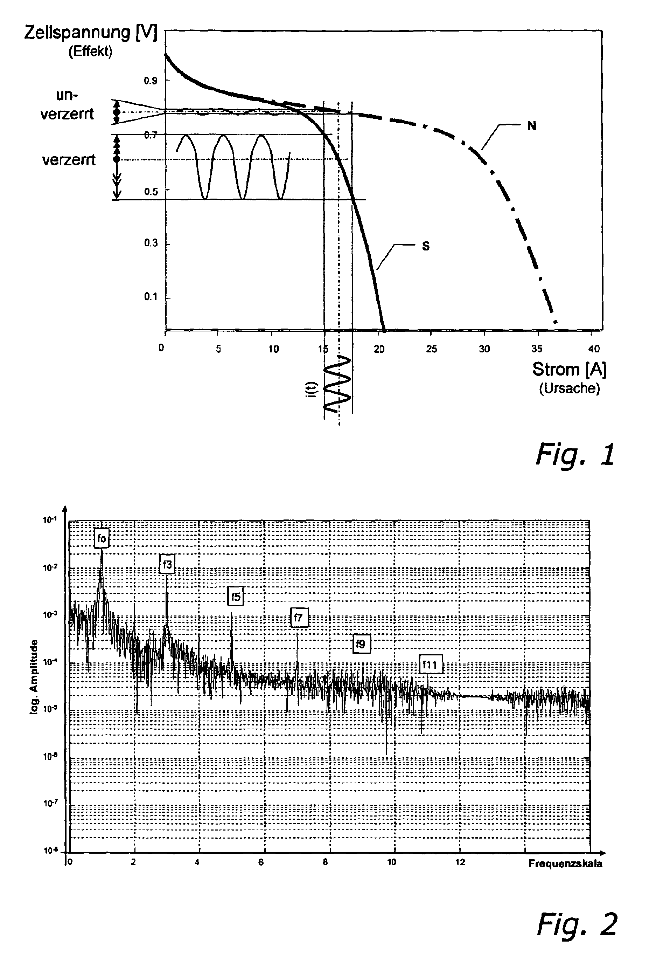

Der Verlauf von U/I Kurven ist in bestimmten Bereichen linear und in anderen nichtlinear. Wenn in einem linearen Bereich - der z.B. bei der nominalen Leistung liegt - eine klirrfaktorarme, kleine, z.B. sinusförmige Stromänderung eingeprägt wird, dann stellt sich eine oberwellenarme Summenspannung ein, d.h. der Klirrfaktor ist adäquat klein. Falls sich der Klirrfaktor nun vergrößert ist das ein direktes Anzeichen dafür, dass einzelne oder mehrere Zellspannungskurven sich im nichtlinearen Bereich befinden, z.B. verursacht durch Unterstöchiometrie (siehe früheres Abknicken der U/I Kennlinie in Fig. 1).

Aus den sich einstellenden Spannungsamplituden der Grund- und Oberschwingungen können sowohl im linearem als auch im nichtlinearen Bereich auf den Gradienten der U/I Kennlinie Rückschlüsse gezogen werden und so die Präzision des Ergebnisses gesteigert werden.

Des Weiteren kann erfindungsgemäß durch eine Oberwellenanalyse mittels eingeprägten klirrfaktorarmen Lastsignals gespreizt über den gesamten Lastbereich ein U/I Kennfeld mit dem entsprechenden Streuband ermittelt werden. Das Ergebnis kann zur Einzelzellenüberwachung oder zur Qualitätssicherung verwendet werden.

Um die Selektivität des Verfahrens zu steigern, kann das eingeprägte Signal aus einer Überlagerung von mehreren vorbestimmten Frequenzen bestehen. Die gewählten Frequenzen werden bestimmten Effekten in der Anode, Kathode oder Membrane zugeordnet. Je nach Ort der Schädigung, z.B. in der Anode, entsteht die Verzerrung der eingeprägten Schwingung nur bei der der Anode zugeordneten Frequenz. Wenn das eingeprägte Signal z.B. sinusförmig ist, dann entstehen durch die Verzerrung nur ungeradzahlige Oberwellen (Fourierzerlegung). Um nun die Trennschärfe von überlagerten Signalen zu bewahren, muss bei der Wahl der einzelnen Frequenzen darauf geachtet werden, dass sich mögliche Oberwellen nicht überlagern. Das "Muster", das durch die Transformation der gemessenen Systemantwort in den Zeit-Frequenzbereich entsteht, enthält zusätzliche, verwertbare Informationen.

Die durch Laständerungen in Betrieb der Brennstoffzelle erzeugten Frequenzspektren bewirken ebenfalls eine Klirrfaktoränderung. Durch den Vergleich des zeit/frequenztransformierten Strom- und Spannungssignals kann der Einfluss einer Laständerung herausgerechnet werden.

Eine Klirrfaktoranalyse kann entweder im Zeitbereich durch den Einsatz von Filtern (digitale oder analoge Filter) oder mittels Transformation in den Frequenzbereich (Anwendung aller Arten von Wavelet-Transformationen, Short-Time Fourier-Transformationen oder Fast-Fourier-Transformationen) erfolgen. Der Vorteil der Frequenztransformation liegt darin, dass das Signal/Rauschverhältnis durch diese Transformation deutlich verbessert wird, was wiederum die Sensibilität des Messverfahrens erhöht.

Die Präzision der Auswertung von Signalen, die mittels Short-Time Fourier-Transformation in den Zeit-Frequenzbereich transformiert worden sind, kann gesteigert werden, wenn sich die Klirrfaktorauswertung auf das Leistungsspektrum bezieht und spektrale Energieanteile der ausgebildeten Oberwellen ausgewertet werden.

Sollten interne, elektrische Kurschlüsse, Risse oder Unterbrechungen eingetreten sein, dann kann dies mittels HF-Wellenanalyse von an Schadstellen reflektierten Wellen detektiert werden. Mittels Laufzeit- und/oder Phasenuntersuchungen der reflektierten Welle kann auf die geometrische Position (Ort des Phänomens) sowie auf die Art des Schadens geschlossen werden. Reflektierte Wellen bekommen entweder einen Phasensprung oder werden gleichphasig reflektiert - je nachdem ob sich am Wellenende ein elektrischer Kurzschluss oder eine Unterbrechung befindet.

Erfindungsgemäß ist vorgesehen, dass das vorzugsweise sinusförmige, eingeprägte Strom- oder Spannungssignal zumindest eine Frequenz von 0.1 bis 1000 Hz, vorzugsweise im Bereich von 10 Hz, aufweist oder aus mehreren vorbestimmten Frequenzen zusammengesetzt ist. Das eingeprägte Strom- oder Spannungssignal kann in Form einer Wirk- oder Blindleistung der eigentlichen Last der Brennstoffzelle als kurzer Burst (mit auf die Frequenz bzw. das Frequenzmuster abgestimmter Burstlänge) oder als kontinuierliches Signal überlagert werden.

Beide Methoden können sowohl online während des Betriebs als auch am Prüfstand, beispielsweise zur Qualitätssicherung, angewendet werden.

Gemäß einer vorteilhaften Variante der Erfindung kann vom gemessenen Strom- oder Spannungssignal nur der Wechselstromanteil bzw. der Wechselspannungsanteil ausgewertet werden. Weiters ist es möglich, dass zusätzlich auch deren Gleichspannungs- bzw. Gleichstromanteil für die Auswertung verwendet wird.

Mit dem erfindungsgemäßen Verfahren kann der Einfluss von Laständerungen auf den Klirrfaktor berechnet werden und der sich ergebende Messwert für die Oberwellenanalyse des Strom- oder Spannungssignals verwendet werden.

Weiters ist es möglich, zusammen mit dem direkten Messsignal eine mathematische Ableitung des Gleichanteils des Strom- oder Spannungssignals für die Auswertung zu verwenden.

Schließlich kann erfindungsgemäß zusätzlich der Amplitudenverlauf der Grundschwingung des Strom- oder Spannungssignals für die Auswertung herangezogen werden.

Die Erfindung wird im Folgenden anhand von schematischen Darstellungen und Diagrammen näher erläutert. Es zeigen:
- Fig. 1: U/I-Diagramme einer Einzelzelle in einem korrekten Betriebszustand (N) und einer Einzelzelle im unterstöchiometrischen Betrieb (S);
- Fig. 2: eine Fast-Fourier-Transformation der gemessenen Stackspannung einer unterstöchiometrisch betriebenen Brennstoffzelle mit eingeprägtem Sinusstrom (fo) bei dem sich Oberwellen (f3, f5, f7, ... f11) ausbilden;
- Fig. 3: ein U/I-Diagramm für zwei unterschiedliche Zellen;
- Fig. 4: eine Laststrom-Rampe auf die ein kleiner, sinusförmiger Strom überlagert ist;
- Fig. 5: ein in den Zeit-Frequenzbereich (Morlet Wavelet Transformation) transformiertes Signal der Stackspannung;
- Fig. 6: das erfindungsgemäße Messprinzip in einer schematischen Darstellung;
- Fig. 7: ein Diagramm eines Messergebnisses gemäß Stand der Technik an einer Festoxid-Brennstoffzelle (SOFC); sowie
- Fig. 8: ein Diagramm einer erfindungsgemäßen Messung an der Festoxid-Brennstoffzelle gemäß Fig. 7.

In Fig. 1 ist das U/I-Diagramm einer Einzelzelle im Normalbetrieb N und einer schadhaften bzw. gestörten Einzelzelle S aufgetragen. Der rasche Spannungsabfall bei kleiner Last der Einzelzelle S basiert beispielsweise auf einem unterstöchiometrischen Betrieb der Zelle. Während nun das eingeprägte sinusförmige Stromsignal i(t) im Antwortsignal (Spannungssignal bez. S) Verzerrungen zeigt und Oberwellen detektiert werden können (erhöhter Klirrfaktor), führt das Stromsignal i(t) in Bezug auf N zu einem unverzerrten Sinussignal, von welchem auf einen störungsfreien Normalbetrieb der Einzelzelle N geschlossen werden kann.

Fig. 2 zeigt das logarithmische Amplitudendiagramm einer real gemessenen Stackspannung im unterstöchiometrischen (Luftmangel-) Betrieb. Auf den Laststrom der Brennstoffzelle wurde ein Sinussignal mit der Frequenz fo überlagert und die Stackspannung gemessen. Das Auftreten von nur ungeradzahligen Vielfachen der Grundschwingung (f3, f5, f7, f9, f11) bestätigt, dass die Ursache für die Oberwellen die eingeprägte Sinusschwingung ist (entsprechend der Theorie der Fourierzerlegung) sowie diese eingeprägte Sinusschwingung verzerrt wurde. Das Verhältnis aus der Summe der Oberwellenanteile zur Grundfrequenz wird als Klirrfaktor bezeichnet und steht in Relation zum Grad der Verzerrung und kann damit als kritischer (unterstöchiometrischer) Betrieb der Brennstoffzelle identifiziert werden. Aus der Größe der Amplituden (Grundwelle inkl. Oberwellen) kann wiederum auf die Impedanz des Brennstoffzellenstapels geschlossen werden.

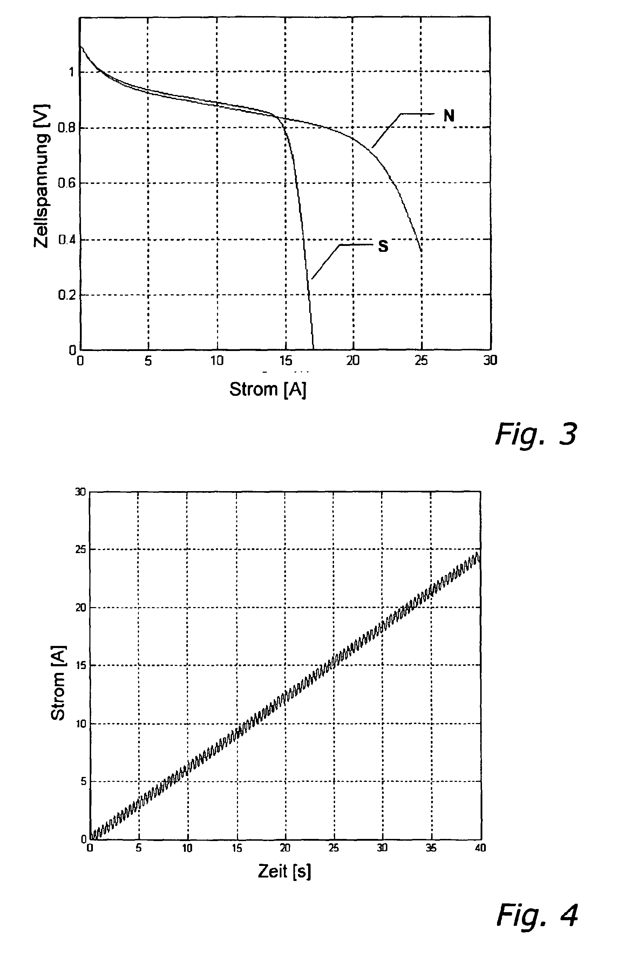

Die Fig. 3 bis Fig. 5 demonstrieren die dynamische Analyse. In diesem Beispiel werden ähnlich wie in Fig. 1 dargestellt, die U/I Kennlinien eines 2-Zellers dargestellt, wobei eine Zelle S kritisch betrieben wird und die zweite Zelle N ausreichend versorgt betrieben wird.

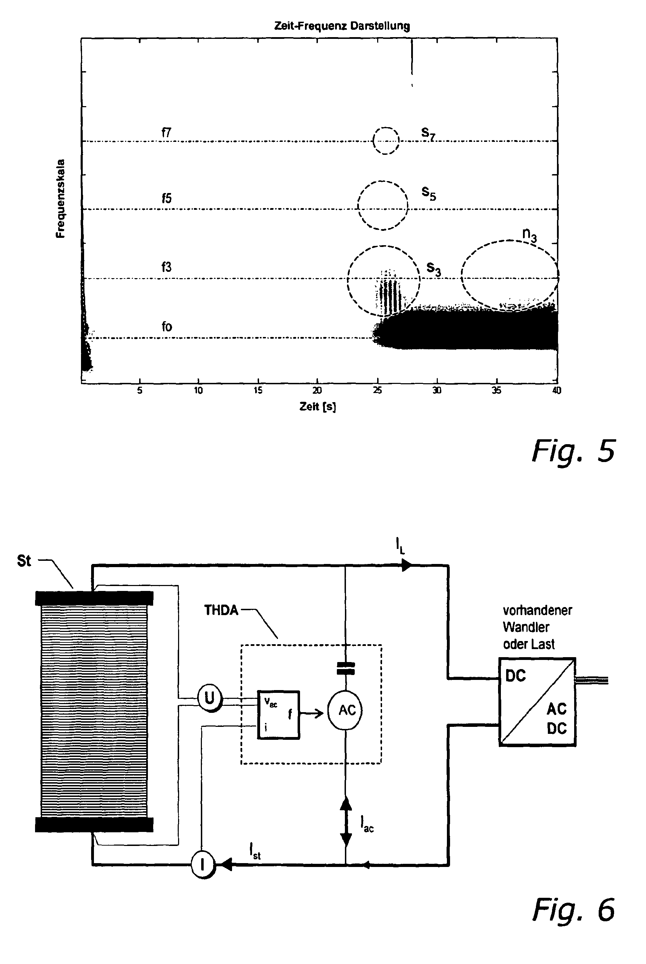

Wird dieser 2-Zeller, wie in Fig. 4 gezeigt mit einer ansteigenden Stromrampe belastet, wobei dem Strom ein kleineres Sinussignal überlagert ist, dann kann durch die Zeit-Frequenztransformation der Summenspannung des 2-Zellers unter Anwendung der Wavelet oder Short-Time Fourier-Transformation die Ausbildung von Oberwellen (Fig. 5) sichtbar gemacht werden. Aufgrund der Dynamik im Lastsignal, kann die Fast-Fourier-Transformation hier nicht mehr angewendet werden. Das erste Auftreten von Oberwellen (siehe S₃, S₅, S₇ in Fig. 5) wird bei t = 25 s detektiert bzw. bei 15 A Laststrom, was genau dem Zeitpunkt bzw. Strom des Abknickens von Zelle S aufgrund ihrer unterstöchiometrischen Luftversorgung entspricht (siehe Fig. 3). Zudem beginnen sich im Bereich ab 32 s bzw. bei Lastströmen über 20A erneut Oberwellen auszubilden (siehe n₃), was nun auch das Abknicken und damit den kritischen Bereich für Zelle N andeutet. Die Trennschärfe zwischen den einzelnen Oberwellen hängt von der gewählten Abtastfrequenz, der Fensterweite (Anzahl der Messpunkte) und der Wahl der Grundfrequenz ab. Der Einfluss des Signalrauschens wird bei der Auswertung im Frequenzbereich deutlich reduziert, weil sich nur der spektrale Rauschanteil (d.h. Rauschamplituden pro Frequenzeinheit) auf die Oberwellenanteile auswirkt.

Die Messtechnik ist schematisch in Fig. 6 dargestellt. Es werden sowohl der Stackstrom I als auch die Stackspannung U des Stacks oder Substaks St gemessen. Parallel dazu wird ein klirrfaktorarmes Strom- oder Spannungssignal mittels steuerbarer Strom-/Spannungssenke THDA (total harmonic distortion analysis) der eigentlichen Stacklast überlagert. Um zu vermeiden, dass nutzbare Wirkleistung der Brennstoffzelle verbraucht wird, kann eine Kapazität oder Induktivität dazwischen geschaltet werden, die dann eine entsprechende Blindleistung erzeugen. Da sehr viele Einzellzellen in Serie geschaltet eine hohe Gleichspannung ergeben, diese aber nicht relevant für diese Messmethode ist, wird nur der Wechselanteil der Stackspannung hochaufgelöst digitalisiert.

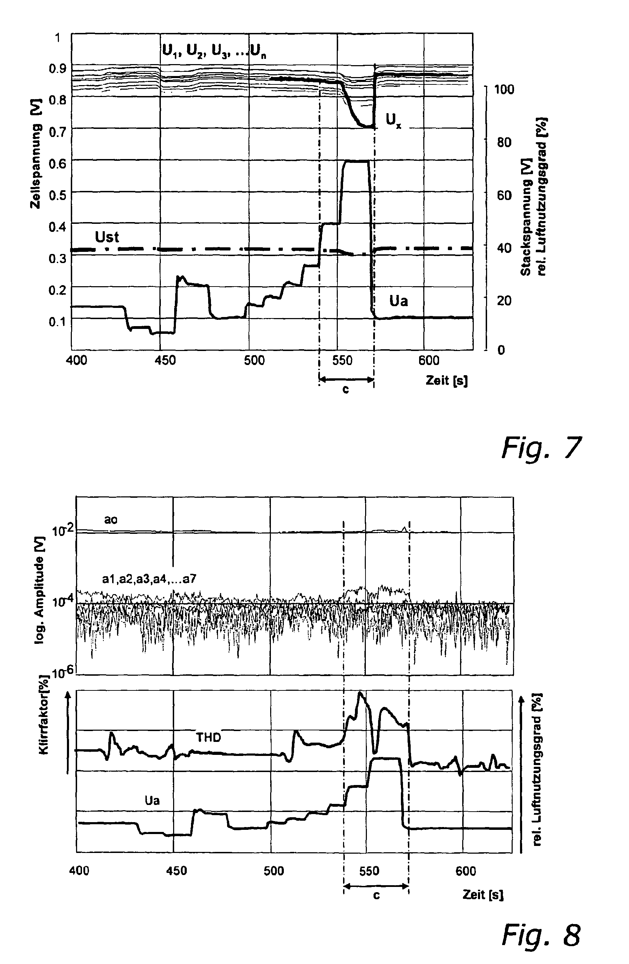

Fig. 7 zeigt das Messergebnis gemäß Stand der Technik an einer Festoxid-Brennstoffzelle (SOFC) mit 50 Einzelzellen, die kathodenseitig mit immer weniger Luftmassenstrom (Kurve Ua) - d.h. einen immer höheren Luftnutzungsgrad - bei konstanter Last betrieben wird, solange bis eine erste Zellspannung Uₓ wegen Unterversorgung erstmalig und dann deutlich einbricht (Zeitpunkt = 540s bzw. 555s, Bereich c in Fig. 7). Die Auswertung der Stacksummenspannung Uₛₜ von ca. 42 V alleine würde noch keinen kritischen Betrieb erkennen lassen, weil die Summenspannung nur ein statistisches Maß über die 50 einzelnen Zellspannungen darstellt. Erst die Einzelspannungsmessung (U₁, U₂, U₃, ... Uₙ) deutet den Einbruch einer einzelnen Zelle und damit kritischen Betrieb an.

Parallel dazu wurde dem Laststrom eine klirrfaktorarme Schwingung überlagert und die Stackspannung Uₛₜ nach dem erfindungsgemäßen Verfahren ausgewertet (siehe Fig. 8). Während die Amplitude der Grundschwingung ao im Wesentlichen unverändert bleibt, ist an den Amplituden der Oberwellen a1, a2, a3, ... a7 zu erkennen, dass sich zum Zeitpunkt der Luftunterversorgung Änderungen ausbilden (oberes Teilbild von Fig. 8, Bereich c) sowie dass der Klirrfaktor THD in diesem Bereich signifikant angestiegen ist (unteres Teilbild von Fig. 8). Unmittelbar nach Aufhebung dieses kritischen Betriebs mittels Vergrößern des Luftmassenstroms (siehe Kurve Ua) sinkt der Klirrfaktor THD wieder auf seinen Ausgangswert.

## Patentansprüche

1. Verfahren zur Überwachung des Betriebszustandes eines Brennstoffzellenstapels bestehend aus einer Vielzahl von in Serie geschalteten Einzelzellen, **dadurch gekennzeichnet, dass** dem Brennstoffzellenstapel ein niederfrequentes Strom- oder Spannungssignal eingeprägt wird, dass das sich ergebende Spannungs- oder Stromsignal gemessen wird und dass aus zumindest einer Änderung des Oberwellenanteils des Signals auf den Betriebszustand von Einzelzellen des Brennstoffzellenstapels geschlossen wird.

2. Verfahren nach Anspruch 1, **dadurch gekennzeichnet, dass** von einem sich vergrößernden Oberwellenanteil des Signals auf einen nichtlinearen Betriebszustand zumindest einer der Einzelzellen des Brennstoffzellenstapels geschlossen wird.

3. Verfahren nach Anspruch 1 oder 2, **dadurch gekennzeichnet, dass** durch eine Oberwellenanalyse mittels eines eingeprägten klirrfaktorarmen Lastsignals gespreizt über den gesamten Lastbereich ein Strom/Spannungs-Kennfeld mit einem entsprechenden Streuband ermittelt wird.

4. Verfahren nach einem der Ansprüche 1 bis 3, **dadurch gekennzeichnet, dass** die Strom- und Spannungssignale während des Betriebs des Brennstoffzellenstapels durch eine Transformation von Spannung und Strom in den Zeit-Frequenzbereich oder durch eine Fourier-Transformation ausgewertet werden.

5. Verfahren nach einem der Ansprüche 1 bis 3, **dadurch gekennzeichnet, dass** die Strom- und Spannungssignale während des Betriebs des Brennstoffzellenstapels mittels analoger oder digitaler Filterung ausgewertet werden.

6. Verfahren nach einem der Ansprüche 1 bis 5, **dadurch gekennzeichnet, dass** mittels Hochfrequenz-Wellenanalyse an Schadstellen im Brennstoffzellenstapel reflektierte Wellen detektiert werden, sowie dass mittels Laufzeit- und/oder Phasenbestimmung der reflektierten Welle der geometrische Ort und/oder die Art der Schadens bestimmt werden.

7. Verfahren nach Anspruch 6, **dadurch gekennzeichnet, dass** aus einem Phasensprung der reflektierten Welle auf einen elektrischen Kurzschluss in einer der Einzelzellen geschlossen wird.

8. Verfahren nach Anspruch 6, **dadurch gekennzeichnet, dass** aus einer gleichphasigen Reflexion auf eine elektrische Unterbrechung geschlossen wird.

9. Verfahren nach einem der Ansprüche 1 bis 8, **dadurch gekennzeichnet, dass** dem Brennstoffzellenstapel ein niederfrequentes, sinusförmiges Strom- oder Spannungssignal eingeprägt wird.

10. Verfahren nach einem der Ansprüche 1 bis 9, **dadurch gekennzeichnet, dass** das eingeprägte Strom- oder Spannungssignal zumindest eine Frequenz von 0.1 Hz bis 1000 Hz, vorzugsweise im Bereich von 10 Hz, aufweist.

11. Verfahren nach einem der Ansprüche 1 bis 9, **dadurch gekennzeichnet, dass** der Brennstoffzellenstapel mit einem beispielsweise zeitlich linear ansteigenden oder abfallenden Laststrom belastet wird, welchem ein vorzugsweise sinusförmiges Stromsignal kleiner Amplitude überlagert wird.

12. Verfahren nach einem der Ansprüche 1 bis 9, **dadurch gekennzeichnet, dass** das eingeprägte Strom- oder Spannungssignal eine Überlagerung von mehreren vorbestimmten Frequenzen darstellt.

13. Verfahren nach einem der Ansprüche 1 bis 9, **dadurch gekennzeichnet, dass** das eingeprägte Strom- oder Spannungssignal in Form einer Wirk- oder Blindleistung der eigentlichen Last der Brennstoffzelle als kurzer Burst oder als kontinuierliches Signal überlagert wird.

14. Verfahren nach einem der Ansprüche 1 bis 9, **dadurch gekennzeichnet, dass** vom gemessenen Strom- oder Spannungssignal nur der Wechselstromanteil bzw. der Wechselspannungsanteil ausgewertet wird.

15. Verfahren nach einem der Ansprüche 1 bis 9, **dadurch gekennzeichnet, dass** vom gemessenen Strom- oder Spannungssignal zusätzlich auch der Gleichspannungs- bzw. Gleichstromanteil für die Auswertung verwendet wird.

16. Verfahren nach einem der Ansprüche 1 bis 9, **dadurch gekennzeichnet, dass** der Einfluss von Laständerungen auf den Klirrfaktor berechnet wird und dass der sich ergebende Messwert für die Oberwellenanalyse des Strom- oder Spannungssignals verwendet wird.

17. Verfahren nach einem der Ansprüche 1 bis 9, **dadurch gekennzeichnet, dass** eine mathematische Ableitung des Strom- oder Spannungssignals für die Auswertung verwendet wird.

18. Verfahren nach einem der Ansprüche 1 bis 9, **dadurch gekennzeichnet, dass** der Amplitudenverlauf der Grundschwingung des Strom- oder Spannungssignals für die Auswertung herangezogen wird.

## Claims

1. A method for monitoring the operational state of a fuel cell stack comprising a plurality of individual cells connected in series, wherein a low-frequency current or voltage signal is impressed on the fuel cell stack, and wherein the resulting current or voltage signal is measured, and wherein the operational state of individual cells of the fuel cell stack is inferred from at least one change in the harmonic content of the signal.

2. A method according to claim 1, wherein increasing harmonic content of the signal permits to infer a non-linear operational state of at least one single cell of the fuel cell stack.

3. A method according to claim 1 or 2, wherein by analysis of harmonics, using an impressed low-THD load signal spread over the whole load range, a field of current/voltage curves with corresponding dispersion band may be obtained.

4. A method according to any of claims 1 to 3, wherein the current and voltage signals during operation of the fuel cell stack are evaluated by a transformation of current and voltage into the time-frequency domain or by a Fourier transformation.

5. A method according to any of claims 1 to 3, wherein the current and voltage signals during operation of the fuel cell stack are evaluated with the use of analogue or digital filters.

6. A method according to any of claims 1 to 5, wherein waves that are reflected at defective locations in the fuel cell stack are detected by high frequency wave analysis, and the geometric location of the phenomenon and the kind of defect are determined by considering propagation time and/or phase relations of the reflected wave.

7. A method according to claim 6, wherein an electric short-circuit in one of the individual cells is inferred from a phase jump of the reflected wave.

8. A method according to claim 6, wherein an electric interruption is inferred from a continuous-phase reflection.

9. A method according to any of claims 1 to 8, wherein a low-frequency sinusoidal current or voltage signal is impressed on the fuel cell stack.

10. A method according to any of claims 1 to 9, wherein the impressed current or voltage signal has a frequency of at least 0.1 to 1000 Hz, and preferably around 10 Hz.

11. A method according to any of claims 1 to 9, wherein the fuel cell stack is subject to a load current rising or falling linearly with time, on which is superimposed a preferably sinusoidal current signal of small amplitude.

12. A method according to any of claims 1 to 9, wherein the impressed current or voltage signal is a superposition of a plurality of predefined frequencies.

13. A method according to any of claims 1 to 9, wherein the impressed current or voltage signal is superimposed on the proper load of the fuel cell as an active or a reactive power component, either as a short burst or as a continuous signal.

14. A method according to any of claims 1 to 9, wherein only the AC-component of the measured current or voltage signal is evaluated.

15. A method according to any of claims 1 to 9, wherein the DC-component is evaluated in addition to the AC-component of the measured current or voltage signal.

16. A method according to any of claims 1 to 9, wherein the influence of load changes on the THD is computed and wherein the resulting measurement value is used for the harmonic analysis of the current or voltage signal.

17. A method according to any of claims 1 to 9, wherein a mathematical derivation of the current or voltage signal is used for the evaluation.

18. A method according to any of claims 1 to 9, wherein the amplitude curve of the fundamental mode of the current or voltage signal is used for the evaluation.

## Revendications

1. Procédé de surveillance de l'état de fonctionnement d'un empilement de piles à combustible, composé d'une pluralité de cellules de pile individuelles, branchées en série, **caractérisé en ce que** l'on inculque à empilement de piles à combustible un signal d'intensité ou de tension à basse fréquence, **en ce que** le signal de tension ou d'intensité résultant est mesuré et **en ce que**, à partir d'au moins une modification de la partie harmonique du signal on tire des conclusions sur l'état de fonctionnement de cellules de pile individuelles de l'empilement de piles à combustible.

2. Procédé selon la revendication 1, **caractérisé en ce que**, à partir d'une partie harmonique, allant en augmentant, du signal on tire des conclusions sur un état de fonctionnement non linéaire au moins d'une des cellules de pile individuelles de l'empilement de piles à combustible.

3. Procédé selon la revendication 1 ou 2, **caractérisé en ce que**, en effectuant une analyse des harmoniques, au moyen d'un signal de charge accentué, à faible facteur de distorsion, on produit un effet d'écartement et l'on détermine, sur l'ensemble de la plage de charge, un champ de caractéristiques intensité/tension ayant une bande de dispersion correspondante.

4. Procédé selon l'une des revendications 1 à 3, **caractérisé en ce que** les signaux d'intensité et de tension sont évalués pendant le fonctionnement de l'empilement de piles à combustible, en procédant à une transformation de l'intensité et de la tension dans le domaine temps-fréquence ou en procédant à une transformation de Fourier.

5. Procédé selon l'une des revendications 1 à 3, **caractérisé en ce que** les signaux d'intensité et de tension sont évalués pendant le fonctionnement de l'empilement de piles à combustible, en procédant à un filtrage analogique ou numérique.

6. Procédé selon l'une des revendications 1 à 5, **caractérisé en ce que**, en procédant à une analyse des ondes de haute fréquence en des points sujets à endommagement dans l'empilement de piles à combustible, on détecte des ondes réfléchies, et l'on détermine le site géométrique et/ou le genre de dommage, par une détermination du temps de parcours et/ou de la phase de l'onde réfléchie.

7. Procédé selon la revendication 6, **caractérisé en ce que**, à partir d'un saut de phase de l'onde réfléchie, on conclue à un court-circuit électrique dans l'une des cellules de pile individuelles.

8. Procédé selon la revendication 6, **caractérisé en ce que**, à partir d'une réflexion à phase identique, on conclue à une interruption électrique.

9. Procédé selon l'une des revendications 1 à 8, **caractérisé en ce que** l'on inculque à l'empilement de piles à combustible un signal d'intensité ou de tension sinusoïdal à basse fréquence.

10. Procédé selon l'une des revendications 1 à 9, **caractérisé en ce que** le signal d'intensité ou de tension inculqué présente au moins une fréquence de 0,1 Hz à 1000 Hz, de préférence dans la fourchette de 10 Hz.

11. Procédé selon l'une des revendications 1 à 9, **caractérisé en ce que** l'empilement de piles à combustible est sollicité par un courant de charge, par exemple augmentant ou diminuant temporellement de façon linéaire, auquel est superposé un signal d'intensité, de préférence sinusoïdal, de petite amplitude.

12. Procédé selon l'une des revendications 1 à 9, **caractérisé en ce que** le signal d'intensité ou de tension inculqué constitue une superposition de plusieurs fréquences prédéterminées.

13. Procédé selon l'une des revendications 1 à 9, **caractérisé en ce que** le signal d'intensité ou de tension inculqué est superposé sous la forme d'une puissance, active ou réactive, de la charge proprement dite de la pile à combustible, sous forme de courte rafale ou de signal continu.

14. Procédé selon l'une des revendications 1 à 9, **caractérisé en ce que**, du signal d'intensité ou de tension mesuré, seule est évaluée la partie d'intensité alternative, ou la partie de tension alternative.

15. Procédé selon l'une des revendications 1 à 9, **caractérisé en ce que**, du signal d'intensité ou de tension mesuré, en plus est également évaluée la partie de tension continue, ou la partie d'intensité continue.

16. Procédé selon l'une des revendications 1 à 9, **caractérisé en ce que** l'influence des fluctuations de charge sur le facteur de distorsion est calculée, et **en ce que** la valeur de mesure, en résultant, est utilisée pour l'analyse des harmoniques du signal d'intensité ou de tension.

17. Procédé selon l'une des revendications 1 à 9, **caractérisé en ce que** l'on utilise une dérivée mathématique du signal d'intensité ou de tension pour effectuer l'évaluation.

18. Procédé selon l'une des revendications 1 à 9, **caractérisé en ce que** l'allure de l'amplitude de l'harmonique fondamentale du signal d'intensité ou de tension est exploitée pour effectuer l'évaluation.
